# EUROPÄISCHE PATENTSCHRIFT

(11) **EP 0 954 444 B1**
(45) Veröffentlichungstag und Bekanntmachung des Hinweises auf die Patenterteilung: **07.11.2001**
(21) Anmeldenummer: 98904067.0
(22) Anmeldetag: 14.01.1998
(51) Int. Cl.: B41F 27/12

(54) **DRUCKPLATTE**
PRINTING PLATE
PLAQUE D'IMPRESSION

(30) Priorität: 31.01.1997 DE 29701585 U
(43) Veröffentlichungstag der Anmeldung: 10.11.1999
(73) Patentinhaber: MAN Roland Druckmaschinen AG, 63075 Offenbach (DE)
(72) Erfinder: LINDNER, Bernd, D-63150 Heusenstamm (DE); SEIB, Berthold, D-63110 Rodgau (DE)
(74) Vertreter: Stahl, Dietmar, Dipl.-Ing.
(86) Internationale Anmeldenummer: EP9800178
(87) Internationale Veröffentlichungsnummer: WO9833651

(56) Entgegenhaltungen:
- EP-A- 0 551 976
- EP-A- 0 579 017

## Beschreibung

Die Erfindung betrifft eine Druckplatte gemäß dem Oberbegriff von Anspruch 1.

Die Druckformen bei Bogenoffsetdruckmaschinen bestehen in der Regel aus um einen Plattenzylinder aufzuspannende biegsame Druckplatten. Damit diese Druckplatte registergerecht auf dem Plattenzylinder des Druckwerkes zum Liegen kommt, sind an der dem Druckanfang der Druckplatte zugeordneten Kante Registerstanzungen in Form von Lochungen bzw. Ausstanzungen angebracht, welche mit entsprechenden Paßstiften oder sonstigen Formteilen im Bereich der Klemmschiene zusammenwirken. Dadurch wird die biegsame Platte bereits vor der Befestigung an der dem Druckanfang zugeordneten Kante sowohl in Seiten- als auch Umfangsrichtung ausgerichtet.

Die am weitesten verbreiteten Druckplatten für Bogenoffsetdruckmaschinen bestehen aus dünnen Aluminiumblech. Bei derartigen Alu-Druckplatten ist es in Verbindung mit den zuvor kurz geschilderten Registerstanzungen nebst Registerstiften möglich, die korrekte Anlage der Druckplatte mit ihren Stanzungen an den Registermitteln des Zylinders durch eine elektrische Abfrage festzustellen. Dazu sind entweder die Registerstifte insgesamt bzw. Teile dieser Registerstifte elektrisch isoliert gegenüber dem Plattenzylinder angeordnet, so daß durch eine korrekt im Bereich der Registerstanzungen an den Stiften anliegende Druckplatte die Isolierung nach Art eines Schalters überbrückt wird. Eine Druckplatte mit an der dem Druckanfang zugeordneten Kante angebrachten Registerstanzungen, die mit elektrisch abfragbaren Registerstiften zusammenwirkt, ist aus der DE 42 26 780 C2 bekannt. Aus der DE 43 38 664 C2 ist es ferner bekannt, daß derartige elektrisch abfragbare Registereinrichtungen an den Plattenzylindern von Druckmaschinen es erlauben, einen Druckplattenwechselvorgang zu automatisieren. So ist es möglich, das Schließen (Befestigen) einer neu zuzuführenden Druckplatte automatisch in Abhängigkeit der registergerechten Anlage der Druckplatte auszuführen. Ferner ist es ebenfalls möglich, nach Öffnen der Druckanfang-Klemmschiene festzustellen, ob die gebrauchte Druckplatte aus dem Klemmspalt heraus gefördert worden ist.

Neben Druckplatten aus dünnem Aluminiumblech werden bei Bogenoffsetdruckmaschinen ebenfalls auch Druckplatten in Form dünner Kunststoff-Folien verwendet. Der Vorteil derartiger Kunststoff-Folien liegt dabei darin, daß es mit bestimmten Filmbelichtungsgeräten möglich ist, entsprechend ausgebildete (beschichtete) Kunststoff-Folien zu belichten und somit die farbannehmenden von den nichtfarbannehmenden Stellen zu strukturieren.

Um diese Kunststoff-Folien als Druckplatten registergerecht einzupassen zu können, werden diese entsprechend dem an der Druckanfangschiene installierten Registersystem mit Stanzungen versehen. Da das Kunststoffmaterial derartiger Druckfolien aber nicht elektrisch leitfähig bzw. nicht im vorgesehenen Maße elektrisch leitfähig ist, kann eine elektrische Registerkontrolle der zuvorstehend skizzierten Art nicht verwendet werden. Bei einer Druckmaschine mit einer derartigen elektrischen Registerkontrolle muß diese bei Verwendung derartiger Druckfolien abgeschaltet werden bzw. die automatisierten und aufeinander folgenden Vorgänge eines Druckplattenwechselvorganges müssen von einer Bedienperson überwacht und manuell gesteuert werden.

Aufgabe der vorliegenden Erfindung ist es daher, eine Druckplatte gemäß dem Oberbegriff von Anspruch 1 derartig weiterzubilden, so daß sich unter Vermeidung der zuvorstehend genannten Nachteile eine Erweiterung des Einsatzsbereiches ergibt.

Gelöst wird diese Aufgabe durch die kennzeichnenden Merkmale von Anspruch 1. Weiterbildungen der Erfindung ergeben sich aus den Unteransprüchen.

Nach der Erfindung ist vorgesehen, daß die aus elektrisch nichtleitendem Material bestehende Druckplatte (Kunststoff-Folie) zumindest in den für die Registerstanzungen vorgesehenen Bereich eine Schicht elektrisch leitfähigen Materials aufweist. Dabei kann vorgesehen sein, daß diese Schicht elektrisch leitfähigen Materials sich über die gesamte Formatbreite der Druckplatte entlang der dem Druckanfang zugeordneten Kante der Platte erstreckt (Streifen dünner Alu-Folie). Auch kann vorgesehen sein, daß die Schicht elektrisch leitfähigen Materials (Alu-Folie) vor dem Stanzen der Druckplatte an den für die Stanzungen vorgesehenen Orten der Druckplattenvorderkante aufgeklebt wird. Vorzugsweise sind dabei die auf die Druckplatte aufzuklebenden elektrisch leitfähigen Schichten als selbstklebende Flächenstücke ausgebildet und werden erst kurz vor dem Stanzvorgang an den für die Stanzung vorgesehenen Stellen im Bereich der Druckplattenvorderkante angebracht.

Des weiteren erfolgt die Erläuterung eines Ausführungsbeispieles der Erfindung anhand der Zeichnungen.

Es zeigt:
- Fig. 1: eine Druckplatte gemäß der Erfindung mit den angebrachten Stanzungen und
- Fig. 2: eine Druckplatte mit den aufgeklebten elektrisch leitfähigen Schichten vor dem Stanzen.

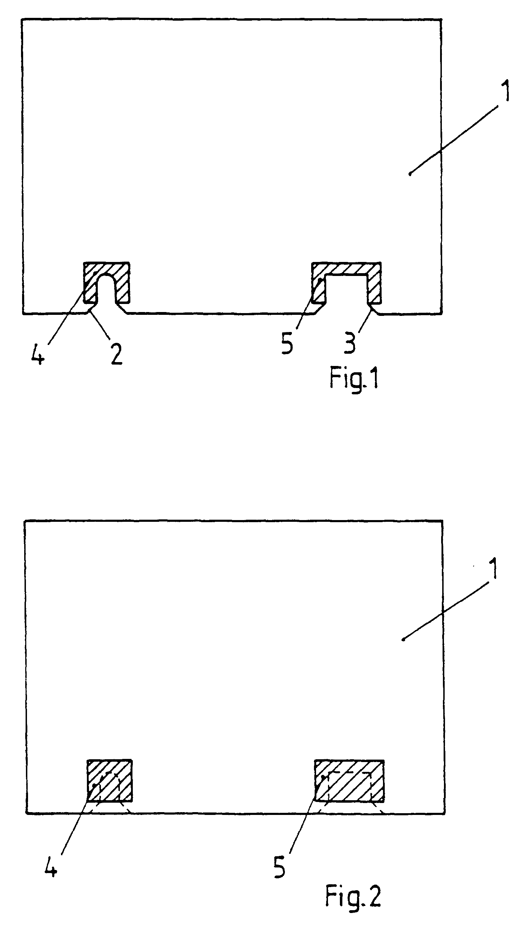

Fig. 1 und 2 zeigen jeweils eine Druckplatte 1, welche aus elektrisch nichtleitfähigem Kunststoffmaterial besteht. Wie in Figur 1 dargestellt, werden an der dem Druckanfang der Druckplatte 1 zugeordneten Kante Stanzungen 2, 3 angebracht, welche mit in den Figuren nicht dargestellten und am Plattenzylinder der Druckmaschine angebrachten Registerstiften bzw. entsprechend ausgebildeten Formteilen zusammenwirken.

Vor dem Einbringen der Stanzungen 2, 3 an der Vorderkante der Druckplatte 1 werden an den für die Stanzung vorgesehenen Stellen der Druckplatte elektrisch leitfähige Schichten 4, 5 auf der Oberfläche der Druckplatte 1 angebracht (Fig. 2). Bei diesen elektrisch leitfähigen Schichten 4, 5 handelt es sich vorzugsweise um rechteckige Stücke aus dünner Alu-Folie, deren eine Seite selbstklebend ausgebildet ist.

In Figur 2 sind dabei die für die Stanzungen vorgesehenen Bereiche an der Vorderkante der Druckplatte 1 gestrichelt angeordnet. Ferner kann vorgesehen sein, die elektrisch leitfähigen Schichten 4, 5 in Form der elektrisch selbstklebenden Alu-Folien entweder auf der beim Drucken mit der Druckplatte 1 außenliegenden Seite der Druckplatte 1 oder der zum Plattenzylinder weisenden Seite anzubringen. Wesentlich ist dabei lediglich, daß nach Einbringen der Stanzungen 2, 3 an der Vorderkante der Druckplatte 1 (Figur 1) die Schnittkante der elektrisch leitfähigen Schichten 4, 5 in elektrisch leitenden Kontakt mit den entsprechenden Registerstiften bzw. Formstücken des Plattenzylinders gebracht werden kann.

### Bezugszeichenliste

- 1: Druckplatte
- 2: Stanzung
- 3: Stanzung
- 4: elektrisch leitfähige Schicht
- 5: elektrisch leitfähige Schicht

## Patentansprüche

1. Druckplatte, insbesondere für Bogenoffsetdruckmaschinen, bestehend aus einer auf einem Plattenzylinder aufspannbaren Platte aus elektrisch nichtleitendem Material, wobei die Platte in zumindest einem Bereich Stanzungen oder Lochungen aufweist, welche mit am Plattenzylinder angebrachten Registerstiften oder sonstigen Formteilen zusammenwirken,
**dadurch gekennzeichnet,**
**daß** die Druckplatte (1) in wenigstens einem für eine einzubringende Stanzung (2, 3) vorgesehenen Bereich eine elektrisch leitfähige Schicht (4, 5) aufweist.

2. Druckplatte nach Anspruch 1,
**dadurch gekennzeichnet,**
**daß** die Druckplatte (1) bei mehreren voneinander beabstandeten Stanzungen (2, 3) in diesen Bereichen jeweils eine elektrisch leitfähige Schicht (4, 5) aufweist.

3. Druckplatte nach Anspruch 1 oder 2,
**dadurch gekennzeichnet,**
**daß** die elektrisch leitfähige Schicht (4, 5) als eine dünne Metallschicht ausgebildet ist.

4. Druckplatte nach Anspruch 3,
**dadurch gekennzeichnet,**
**daß** die Metallschicht Aluminium aufweist bzw. aus Aluminium besteht.

5. Druckplatte nach einem der vorhergehenden Ansprüche,
**dadurch gekennzeichnet,**
**daß** die elektrisch leitfähige Schicht (4, 5) als ein auf einer Seite der Druckplatte (1) mittels einer selbstklebenden Schicht anbringbares Element ausgebildet ist.

6. Druckplatte nach einem der vorhergehenden Ansprüche,
**dadurch gekennzeichnet,**
**daß** die elektrisch leitfähige Schicht (4, 5) auf der beim Drucken mit der Druckplatte (1) außenliegenden Seite der Druckplatte (1) angeordnet ist.

7. Druckplatte nach einem der Ansprüche 1 bis 5,
**dadurch gekennzeichnet,**
**daß** die elektrisch leitfähige Schicht (4, 5) auf der zum Plattenzylinder weisenden Seite der Druckplatte (1) angeordnet ist.

## Claims

1. Printing plate, particularly for offset sheet printing presses, consisting of a plate of electrically non-conductive material which can be tensioned on to a plate cylinder, wherein the plate in at least one region has stampings or perforations, which cooperate with register pins or other shaped parts fitted to the plate cylinder, **characterised in that** the printing plate (1) has an electrically conductive layer (4, 5) in at least one region envisioned for a stamping (2, 3) to be applied.

2. Printing plate according to Claim 1, **characterised in that** the printing plate (1) has in the case of several stampings (2, 3) spaced from one another an electrically conductive layer (4, 5) in each case in these regions.

3. Printing plate according to Claim 1 or 2, **characterised in that** the electrically conductive layer (4, 5) is constructed as a thin metal layer.

4. Printing plate according to Claim 3, **characterised in that** the metal layer comprises aluminium or consists of aluminium.

5. Printing plate according to one of the preceding Claims, **characterised in that** the electrically conductive layer (4, 5) is constructed as an element which can be applied by means of a self-adhesive layer to one side of the printing plate (1).

6. Printing plate according to one of the preceding Claims, **characterised in that** the electrically conductive layer (4, 5) is arranged on the side of the printing plate (1) lying outwardly during printing with the printing plate (1).

7. Printing plate according to one of Claims 1 to 5, **characterised in that** the electrically conductive layer (4, 5) is arranged on the side of the printing plate (1) facing the plate cylinder.

## Revendications

1. Plaque d'impression, en particulier pour des machines d'impression offset à feuilles, constituée d'une plaque, pouvant être tendue sur un cylindre porte-plaque, en une matière électriquement non conductrice, la plaque présentant, dans au moins une zone, des orifices ou perçages, qui coopèrent avec des broches de repérage ou des pièces quelconques agencées sur le cylindre porte-plaque,
**caractérisée en ce que** la plaque d'impression (1) présente, dans au moins une zone prévue pour un orifice (2, 3) devant être réalisé, une couche électriquement conductrice (4, 5).

2. Plaque d'impression selon la revendication 1,
**caractérisée en ce que** la plaque d'impression (1), dans le cas de plusieurs orifices (2, 3) écartés les uns des autres, présente, dans ces zones, à chaque fois une couche électriquement conductrice (4, 5).

3. Plaque d'impression selon la revendication 1 ou 2,
**caractérisée en ce que** la couche électriquement conductrice (4, 5) est réalisée comme une couche métallique mince.

4. Plaque d'impression selon la revendication 3,
**caractérisée en ce que** la couche métallique présente de l'aluminium ou est constituée d'aluminium.

5. Plaque d'impression selon une des revendications précédentes,
**caractérisée en ce que** la couche électriquement conductrice (4, 5) est réalisée comme un élément pouvant être appliqué sur une face de la plaque d'impression (1) au moyen d'une couche autocollante.

6. Plaque d'impression selon une des revendications précédentes,
**caractérisée en ce que** la couche électriquement conductrice (4, 5) est agencée sur la face, externe lors de l'impression par la plaque d'impression (1), de la plaque d'impression (1).

7. Plaque d'impression selon une des revendications 1 à 5,
**caractérisée en ce que** la couche électriquement conductrice (4, 5) est agencée sur la face, orientée vers le cylindre porte-plaque, de la plaque d'impression (1).
